# EUROPEAN PATENT SPECIFICATION

(11) **EP 0 723 293 B1**
(45) Date of publication and mention of the grant of the patent: **01.08.2001**
(21) Application number: 94119955.6
(22) Date of filing: 16.12.1994
(51) Int. Cl.: H01L 23/433, H01L 21/48

(54) **Semiconductor device with a heat sink and method of producing the heat sink**
Halbleiteranordnung mit einer Wärmesenke und Herstellungsverfahren der Wärmesenke
Dispositif semi-conducteur ayant un dissipateur de chaleur et procédé de fabrication du dissipateur de chaleur

(43) Date of publication of application: 24.07.1996
(73) Proprietor: SEIKO EPSON CORPORATION, Shinjuku-ku Tokyo (JP)
(72) Inventor: Otsuki, Tetsuya, c/o Seiko Epson Corporation, Suwa-shi, Nagano-ken (JP); Hama, Norikata, c/o Seiko Epson Corporation, Suwa-shi, Nagano-ken (JP)
(74) Representative: Hoffmann, Eckart, Dipl.-Ing.

(56) References cited:
- EP-A- 0 548 497
- EP-A- 0 658 935
- US-A- 5 686 361
- PATENT ABSTRACTS OF JAPAN vol. 018 no. 277 (E-1554) ,26 May 1994 & JP-A-06 053390 (SEIKO EPSON CORP) 25 February 1994,
- PATENT ABSTRACTS OF JAPAN vol. 011 no. 187 (E-516) ,16 June 1987 & JP-A-62 018046 (TOSHIBA CORP) 27 January 1987,

## Description

### BACKGROUND OF THE INVENTION

### Field of the Invention

The present invention relates to a semiconductor device with a heat sink and a method of producing the heat sink, and particularly to a semiconductor device with a heat sink and a method of producing the heat sink, in which the heat radiating surface of the heat sink of the convex type ( 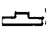 ) as a heat radiator is exposed to improve the heat radiation property and reliability of the device.

### Description of the Prior Art

Recently, with the increase of power consumption of a device such as a high integrated CMOS LSI, a demand for a low-cost and low-heat-resistant plastic package has become stronger and stronger. As a countermeasure to this, from the viewpoint of material, a method of making a lead frame or sealing resin have a high heat conductivity has been proposed, and from the viewpoint of structure, a method of changing the design of a lead frame or adding a heat sink, that is, a heat radiator has been inspected or has been put into practice.

Though the description of advantages, disadvantages and features of these methods is given away to special books, the method of adding a heat sink to reduce the heat resistance of a package can be regarded as the most orthodox countermeasure for LSIs of power consumption up to about 2W per chip in view of the present situation including the near future one.

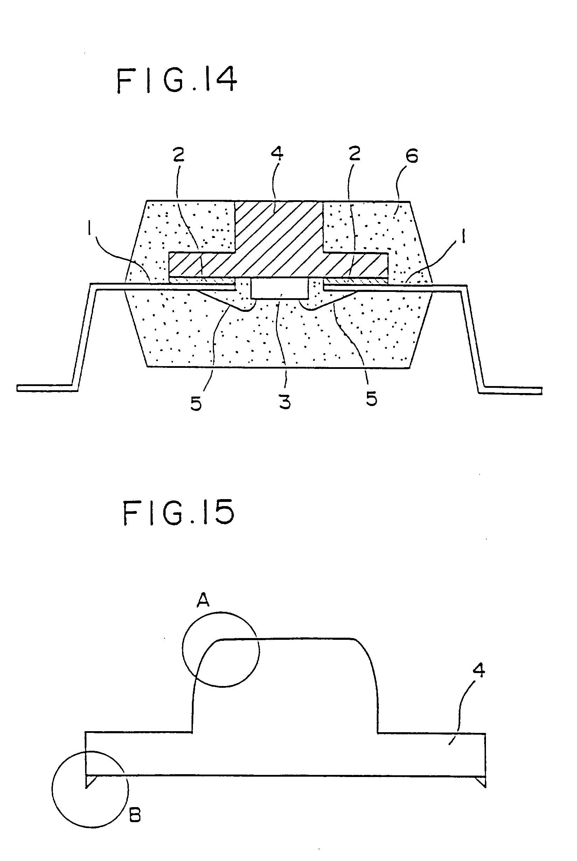

FIG. 14 is a main portion sectional view schematically illustrating a package structure of a conventional semiconductor device with a heat sink of a partially exposed heat radiator type. In FIG. 14, the reference numeral 1 represents each of leads of a lead frame. A number of leads 1 are arranged so that a quadrangular space portion is formed in the center surrounded by the forward end portions of the respective leads 1. A heat sink 4 constituted by a convex body of high heat-conductive metal such as oxygen-free copper (the structure of which will be described later more in detail) is bonded and fixed, at a circumferential portion of its bottom, onto the leads 1 through an insulating plate 2 such as a polyimide plate. A semiconductor chip (semiconductor element) 3 is attached onto the bottom center portion of the heat sink 4 at a position within the above-mentioned space portion by a bonding agent or the like. Bonding pads (not shown) of the semiconductor chip 3 are connected to the corresponding leads 1 through wires 5 respectively.

In the above-mentioned manner, the semiconductor chip 3 connected to the leads 1 and mounted on the position within the above-mentioned space portion is sealed with sealing plastic such as epoxy resin, except part (for example, outside portions) of the respective leads 1 and part (for example, the top surface of a projecting portion) of the heat sink 4, so as to form a package 6. The respective portions of the leads 1 projecting out of the package 6 are bent into predetermined shapes so as to form terminals of the device. Thus, the formation of a semiconductor device with a heat sink is completed.

With the above-mentioned configuration, heat generated from the semiconductor chip 3 in use reaches the top surface of the above-mentioned projecting portion of the heat sink 4 effectively through the body of the heat sink 4 which is a low heat-resistant (high heat-conductive) body. Thus, the heat is radiated by air cooling to the outside from the top surface of the projecting portion of the heat sink 4.

FIG. 15 is an enlarged sectional view of the heat sink illustrated in FIG. 14. A conventional convex heat sink 4 is produced by cutting and rolling in combination. Therefore, even if production is made so that a perfect convex body having a convex portion (that is, projecting portion) which has vertical side surfaces should be obtained as the convex body illustrated in FIG. 14, the body produced in practice has rounded or curved corner portions or irregular cut burrs because of working strain or working defect in cutting or rolling respectively as shown in portions A and B in FIG. 15. Although the cutting burrs can be removed in the following process, it is general to use the heat sink with the curved corners left as they are.

In such a conventional semiconductor device with a heat sink and a conventional method of producing such a heat sink, particularly because the heat sink is produced by machining, it is difficult to obtain proper flatness and parallelism of a top surface of a projecting portion of the heat sink, so that the edge corner surfaces of the projecting portion of the heat sink are curved. Therefore, the top surface of the projecting portion near these edge corner surfaces is inclined like a gentle descent, and in the case where the curvature of the curved surface of an upper portion of a side portion is too large, the above-mentioned inclined portion is involved in resin at the time of sealing with the resin so that the resin is put thereon. Accordingly, there has been a problem that separation occurs at the boundary between the sealing resin and the heat sink to thereby make the reliability of a semiconductor device of this type deteriorate.

In addition, also from the viewpoint of macrostructure, a conventional heat sink has a problem that the adhesive property of the heat sink with the sealing resin becomes low so that troubles caused by this reduction in adhesion reduce the reliability of a semiconductor device.

Further, there have been problems that not only it is difficult for a bonding machine to automatically recognize leads of a lead frame, because the surface of a heat sink has a reflectivity similar to that of the leads, in producing a device, particularly at the time of wire bonding, but also the quality of bonding is not stable because an insulating plate is elastic enough so that it is strained.

JP-A-6 053 390 discloses a semiconductor device according to the prior art portion of claim 1. EP-A-0 658 935 (prior art according to Art. 54(3) EPC) discloses such a semiconductor device in which a solder-plated layer is provided on said top surface of the projecting portion which constitutes an exposed portion of a heat sink.

### SUMMARY OF THE INVENTION

It is an object of the present invention to solve the foregoing problems so as to provide a semiconductor device with a heat sink of a partially exposed heat radiator type in which stable and high reliable wire bonding can be attained at the time of packaging of the semiconductor device and which can be produced with a low cost and has a high heat radiation property, and so as to provide a method of producing such a heat sink.

These objects are achieved with a semiconductor device as claimed in claim 1 and a method as claimed in claims 14 and 15, respectively.

Specific embodiments of the invention are subject-matter of the dependent claims.

According to the present invention, dark color surface treatment such as blackening treatment is conducted onto the surface of the heat sink. Accordingly, at the time of wire bonding, a bonding apparatus can recognize the leads easily to make the wire bonding stable. With the blackening treatment, the adhesive property of the sealing resin to the heat sink is improved to increase the reliability of the semiconductor device.

### BRIEF DESCRIPTION OF THE DRAWINGS

- FIG. 1A: shows a main portion sectional view illustrating a semiconductor device with a heat sink,
- FIG. 1B: shows a schematic sectional view of the heat sink;
- FIG. 2A: shows a main portion sectional view of the heat sink according to the present invention, the surface of which is subjected to dark color treatment such as blackening treatment,
- FIG.2B: shows a main portion bottom plan view of a semiconductor device (unpackaged) with a heat sink which is subjected to dark color treatment;
- FIG. 3: is a sectional view illustrating an example of wire bonding of the semiconductor device of FIG. 1A and 1B;
- FIG. 4: is a sectional view illustrating the state when the wire bonding of FIG. 3 is finished;
- FIG. 5: is a main portion bottom plan view of the semiconductor device (unpackaged) with a heat sink according to the present invention, and having through holes;
- FIG. 6A, 6B and 6C: show views showing in section various steps in an embodiment of the method of producing, only by etching, heat sinks according to the present invention;
- FIG. 7A, 7B, 7C and 7D: show views showing in section various steps (a) through (d) in another embodiment of the method of producing, by etching and pressing, heat sinks according to the present invention;
- FIG. 8: is a sectional view illustrating the state of a first step in producing heat sinks having silver-plated surfaces according to the present invention;
- FIG. 9: shows a sectional view illustrating the state of the device before packaging which uses a heat sink having a silver-plated surface according to the present invention,
- FIG. 9B: shows an explanatory plan view (b) of the same;
- FIG. 10A: shows a sectional view illustrating the state of another embodiment of the device before packaging which is formed by use of a heat sink having a silver-plated surface according to the present invention,
- FIG.10B: shows a plan view of the same;
- FIG. 11A: shows a sectional view illustrating the state of a further embodiment of the device before packaging which is formed by use of a heat sink having a silver-plated surface according to the present invention,
- FIG.11B: shows a plan view of the same;
- FIG. 12A: shows a sectional view illustrating the state of a still further embodiment of the device before packaging which is formed by use of a heat sink having a silver-plated surface according to the present invention,
- FIG.12B: shows a plan view of the same;
- FIG. 13: is a sectional view illustrating another embodiment of the semiconductor device with a heat sink according to the present invention;
- FIG. 14: is a main portion sectional view illustrating a conventional semiconductor device of a exposed radiator type;
- FIG. 15: is a schematic sectional view illustrating a conventional convex heat sink.
- FIG. 16A: is a sectional view of the package according to the present invention, and
- FIG. 16B: is an explanatory view showing an embodiment of the state of provision of the insulator of this package.

### DETAILED DESCRIPTION OF THE PREFERRED EMBODIMENTS

### Basic Structure

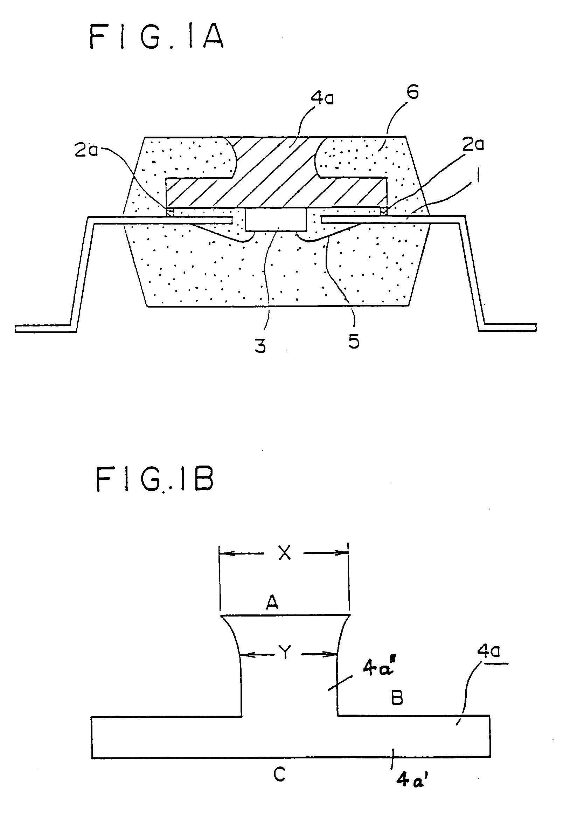

FIG. 1A and 1B typically show a main portion of an embodiment of a semiconductor device with a heat sink according to the present invention. FIG. 1A is a sectional view of the device, and FIG.1B shows a main portion sectional view of the heat sink used in the FIG.1A.

First, in FIG. 1A, the reference numeral 1 represents leads of a lead frame, and 4a represents an convex heat sink made from a high heat-conductive material such as oxygen-free copper or the like. The heat sink 4a is bonded and fixed at its circumferential portion to the leads 1 through an insulating tape 2a such as polyimide. The reference numeral 3 represents a semiconductor chip attached onto the heat sink 4a by a bonding agent or the like. Bonding pads provided on the semiconductor chip 3 are connected to corresponding leads 1 through wires 5 such as gold wires or the like, respectively.

In the embodiment shown (see Fig. 1B), the convex heat sink 4a comprises a base 4a' and a projecting portion 4a" the projecting portion 4a" extending substantially perpendicularly from a portion of the base 4a'. The side of the base 4a' opposite to the projecting portion 4a" defines the bottom surface of the heat sink to which the semiconductor chip 3 is attached.

The semiconductor chip 3 connected to the leads 1 in the above-mentioned manner is sealed with plastics such as epoxy resin, except part of the leads 1 and the top surface of the projecting portion of the heat sink 4a so that a semiconductor device with a package 6 is formed. The portions of the leads 1 projecting out of the package 6 are bent into a predetermined shape so as to form device terminals. Consequently, a semiconductor device with a heat sink of an exposed heat radiation type is completed.

That is, the semiconductor device in the embodiment shown in FIG.1A, is a semiconductor device with a heat sink which is obtained in a manner so that the heat sink 4a and the leads 1 are bonded and fixed through the insulating tape 2a, and then the assembly is sealed with resin or the like after the bonding pads (not-shown) of the semiconductor chip 3 and the inner leads are connected through the wires 5 such as gold wires. Further, the semiconductor device is a semiconductor device with a heat sink, in which in place of a conventional die pad for bonding and fixing the semiconductor chip 3, the semiconductor chip 3 is fixed by use of a high heat-conductive heat sink made from metal or the like, the heat sink being mounted so that the top surface of the heat sink is exposed to the outside of the semiconductor device.

In this case, preferably, the high heat-conductive material of the heat sink consists of a material selected from copper, aluminum, silver, gold, and an alloy of any of the above metal elements. Particularly from the viewpoint of economics, it is preferable to use copper.

A convex heat sink 4a shown in FIG.1B is formed by wet-type etching as will be described later. At that time, the side of the projecting portion is scraped out so that the condition X>Y is established between the width X of the top surface of the projecting portion and the width Y of the projecting portion at the side thereof, when the heat sink is viewed in section.

With respect to the respective surfaces A, B and C of the heat sink 4a, that is, the top surface of the projecting portion, the side surface of the projecting portion and the bottom surface, surface roughness of each of the surfaces A and C is made to be no more than 30 *µ*m. The deviation from parallelism between the surfaces A and C is made to be no more than 30 *µ*m. This means there exists a plane C' which is precisely parallel to surface C wherein the distance between an arbitrary first point of surface A and a corresponding second point of plane C' is no more than 30 *µ*m, the first point and the second point being on the same line normal to surface C. Although it is not always necessary to make the surface B be a mirror surface, it is sufficient if the surface B is made to have a surface roughness of 50 *µ*m.

### Embodiment 1

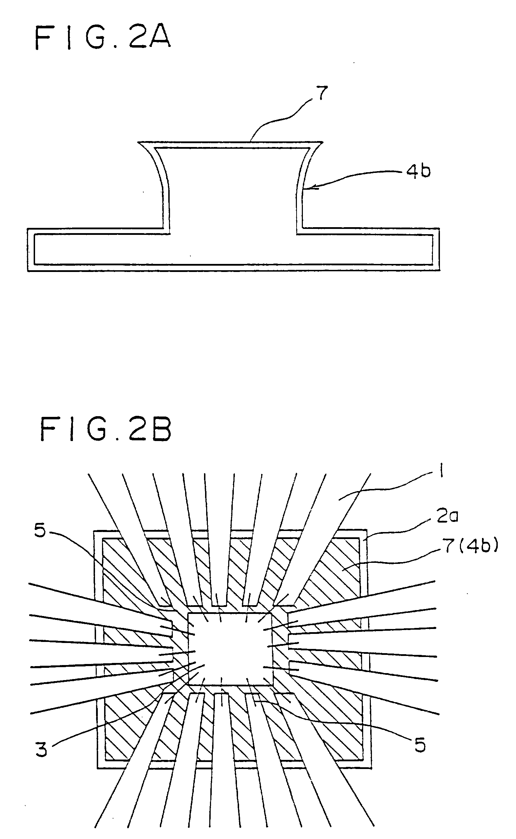

FIG. 2A and 2B typically show an embodiment of the heat sink according to the present invention, which include a partially sectional view in FIG.2A of a heat sink 4b which is obtained, for example, by treating the heat sink 4a used in the basic structure so as to have a dark color treatment, such as blackening treatment layer 7 over the whole surface, and a main portion bottom plan view in FIG.2B of a semiconductor device with the heat sink 4b, before packaging.

In FIG. 2A and 2B, the reference numeral 1 represents leads of a lead frame, and 4b represents a heat sink having a dark color treatment layer 7. The leads 1 and the heat sink 4b are bonded and fixed through an insulating tape 2a such as polyimide in the same manner as in the case of FIG. 1A and 1B. The reference numeral 3 represents a semiconductor chip attached onto the heat sink 4b by a bonding agent. Bonding pads (not-shown) provided on the semiconductor chip 3 and the corresponding leads 1 are connected through wires 5 respectively.

The dark color treatment layer 7 provided on the surface of the above-mentioned heat sink 4b is obtained in a manner so that the heat sink 4a is immersed, for example, in "Ebonol" (tradename, made by MELTEX Inc.) (a strongly alkaline solution) for several seconds so that the surface of the heat sink 4 is oxidized. By projecting such blackening treatment or dark color treatment on the surface like the heat sink 4b having the dark color treatment layer 7, it is possible to obtain an effect that not only the adhesive property of resin in packaging is improved and the recognition of leads by a bonding machine is made easy in wire bonding, but also the prevention of the surface of copper or the like, which is easily eroded, from being deteriorated.

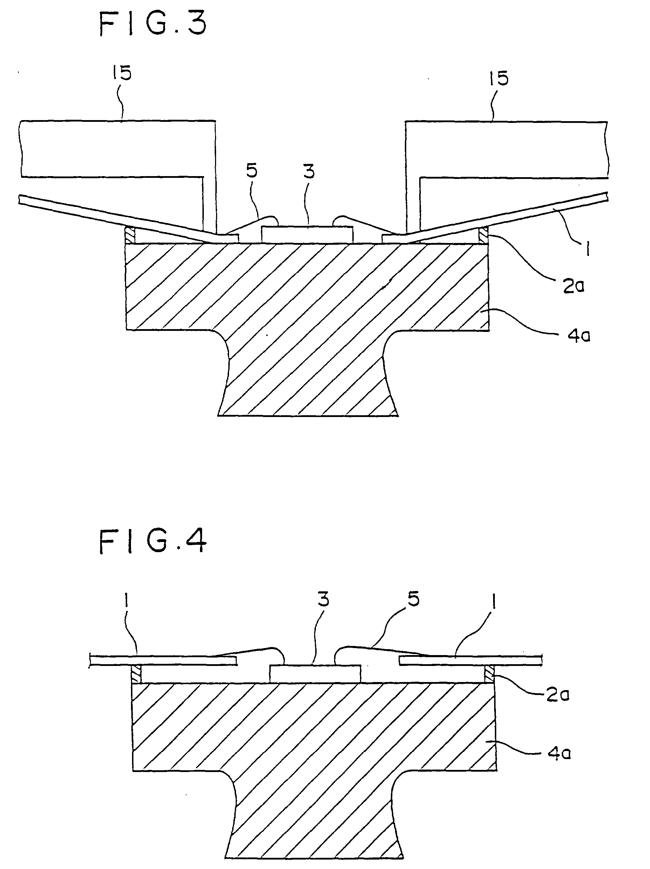

One of the important features of the above-mentioned Embodiment 1 is that the insulating tape 2a is used for bonding the heat sink 4a or 4b onto the leads 1. The effect of the insulating tape which was used above will be described with reference to the sectional explanatory diagrams of FIGs. 3 and 4.

FIG. 3 shows an example of the state of wire bonding. If the forward end portions of the respective leads 1 are pressed down by a lead presser 15, the forward end portions of the leads 1 are brought into contact, with the heat sink 4a with the insulating tape 2a as a fulcrum, so as to be fixed thereto, because the insulating tape 2a is narrow like a tape. Therefore, in this state, the bonding of the wires 5 can be performed stably. If the lead presser 15 is released to its original position after bonding, the leads 1 are restored to their original state on the basis of their elasticity and kept horizontally as shown in FIG. 4, while the leads 1 are insulated from the heat sink 4a by the insulating tape 2a interposed therebetween like a spacer.

With the insulating tape 2a used for making insulation and fixing between the heat sink 4a and the leads 1 as described above, and with the dark color treatment layer 7 provided on the surface of the heat sink 4a as shown in Embodiment 1, the adhesive property of resin in packaging is improved, and a bonding machine becomes easy to recognize leads in wire bonding.

Here, the state of provision of the insulating tape 2a will be discussed. In the case where a heat sink has a substantially square bottom like the heat sink 4b shown in FIG. 2A and 2B, the insulating tape 2a is provided along all the sides of the bottom (in this case four sides).

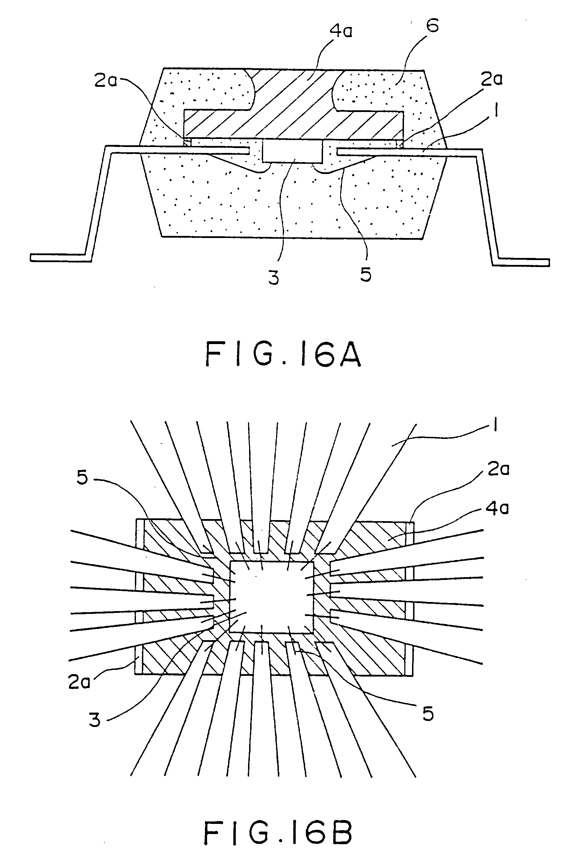

In the case where a rectangular heat sink which is suitable for use for a rectangular package like a heat sink 4a shown in FIG.16A and 16B, however, the length of the respective leads 1 generally varies in accordance with the sides of the bottom and it is therefore preferable to provide the insulating layer 2a along only the sides where the leads become longer (here, the shorter sides of the heat sink). That is, in this configuration, it is possible to increase the length of the leads 1 since the insulating tape 2a supports longer leads 1. Further, this configuration is preferable to satisfy the prior condition that it is better to reduce the insulator in quantity in view of reliability and moisture resistant property.

In amplification of the above-mentioned, by use of such a state of provision, there arises advantages in that it is possible to use leads only in the two directions, not in the four directions, according to circumstances so that it is possible to provide an insulator properly in necessary portions.

Although the dark color treatment layer 7 is provided over the whole surface of the heat sink 4a in the above embodiment, as shown in the drawing FIG.2A, it is not always necessary to provide the dark color treatment layer 7 over the whole surface of the heat sink 4a but, preferably, it is sufficient if the layer 7 is provided on the resin adhesion surface portion and semiconductor element mounting surface portion of the heat sink 4a.

Although both the top and bottom surfaces of the projecting portion of the heat sink 4a or 4b are quadrangular similarly as shown in the drawing FIG. 2B, it is not necessary to make these surfaces have such similar shapes. For example, the four corners of the top surface of the projecting portion may be curved or cut straight.

### Embodiment 2

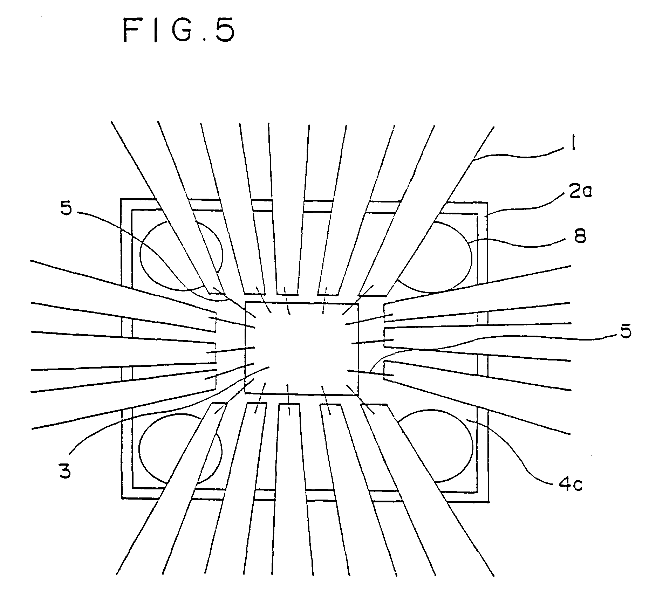

FIG. 5 is a typical explanatory diagram showing another embodiment of the heat sink according to the present invention. Specifically, FIG. 5 is a main portion bottom plan view of a semiconductor device using a heat sink having through holes. In FIG. 5, the reference numeral 1 represents leads of a lead frame, and 4c represents a heat sink. The leads 1 and the heat sink 4c are bonded and fixed through an insulating tape 2a such as polyimide similarly to the above-mentioned manner. The reference numeral 3 represents a semiconductor chip attached onto the heat sink 4c by a bonding agent. Bonding pads provided on the semiconductor chip 3 and the corresponding leads 1 are connected through wires 5 respectively. The reference numeral 8 represents through holes provided in the four corners of the quadrangular base of heat sink 4c, i.e. in portions other than the projecting portion thereof. The through holes 8 are provided at positions between the insulating tape 2a and forward ends of the leads 1, and the number and shape of the through holes 8 are set desirably.

By employing the heat sink 4c with the through holes 8 in the configuration of the present invention, sealing resin is injected also into the through holes 8 in packaging, so that it is possible to improve the adhesive property between the sealing resin and the heat sink. At the same time, molding can be made stiffly in the state that the upper and lower resin portions while constituting a package and sandwiching the leads 1 therebetween are connected with each other tightly through the through holes 8. Thus, there is an effect to obtain a stiff package 6.

### Embodiment 3

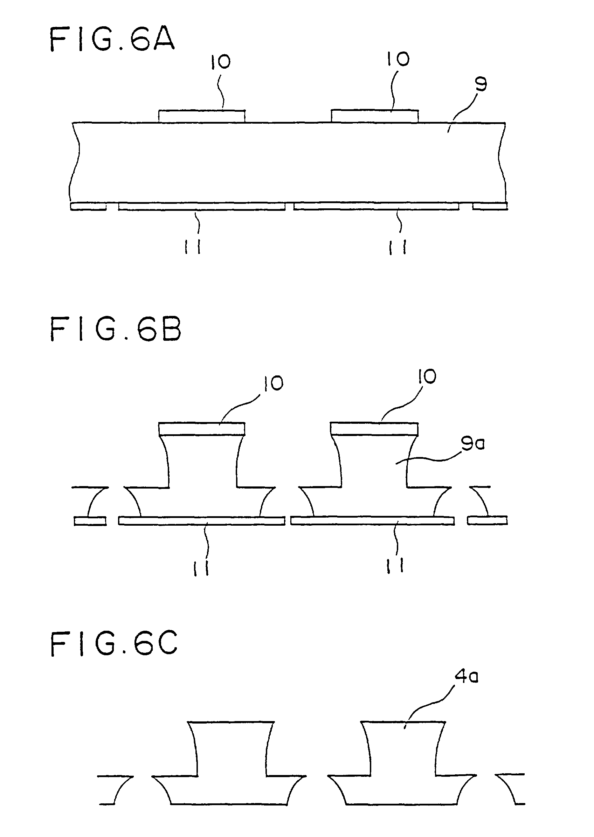

FIG. 6A, 6B and 6C are views including step explanatory diagrams 6A through 6C of an embodiment of the method of producing heat sinks which are used in semiconductor devices with heat sinks according to the present invention. The procedure of the production will be described along the steps shown in the sectional views of FIG. 6A - 6C.

First, in FIG. 6A, on one surface (upper surface in the drawing) of a metal plate 9 such as an oxygen-free copper plate having a thickness identical with the plate thickness of heat sinks to be formed, small resist films 10 are provided with predetermined intervals in order to form projecting portions of the respective heat sinks. Then, on the other surface (lower surface in the drawing) of the plate 9, large resist films 11 each having an area identical with the area of the bottom surface of each of the convex heat sinks are provided with predetermined intervals in the positions corresponding to the small resist films 10.

Next, as shown in FIG. 6B, wet-type etching is performed from both the one and the other surfaces of the plate 9 by use of the large and small resist films 11 and 10 as masks with an etching liquid containing, for example, iron (II) chloride as a main component. The etching is continued till the plate 9 is separated into individual portions divided at positions above the predetermined intervals of the large resist films 11 so that individual convex bodies 9a with the resist films are formed.

Further, as shown in FIG. 6C, the large and small resist films 11 and 10 adhering to the respective convex bodies 9a are eliminated in an ordinary manner so that individual convex heat sinks 4a are obtained.

As is apparent from the above description, this embodiment shows a method of producing heat sinks only by etching. Since the process of this embodiment is carried out, the upper and lower side surfaces are etched so as to be undercut to produce a shape scraped curvedly. Therefore, such projecting portions satisfying the condition of X>Y as described above with respect to the diagram of FIG. 1B can be obtained. The upper and lower surfaces of the plate are masked so as not to be etched so that a surface roughness no more than 30 *µ*m is attained on the respective surfaces A and C among the surfaces A, B and C (refer to the diagram of FIG. 1B of the heat sink 4a, that is, the top surface of the projecting portion, the side surface of the projecting portion, and the bottom surface of the heat sink). The deviation from parallelism (as defined above) between the surfaces A and C is also kept to be no more than 30 *µ*m. In addition, it is ensured that the surface B is formed with a surface roughness of about 50 *µ* m.

### Embodiment 4

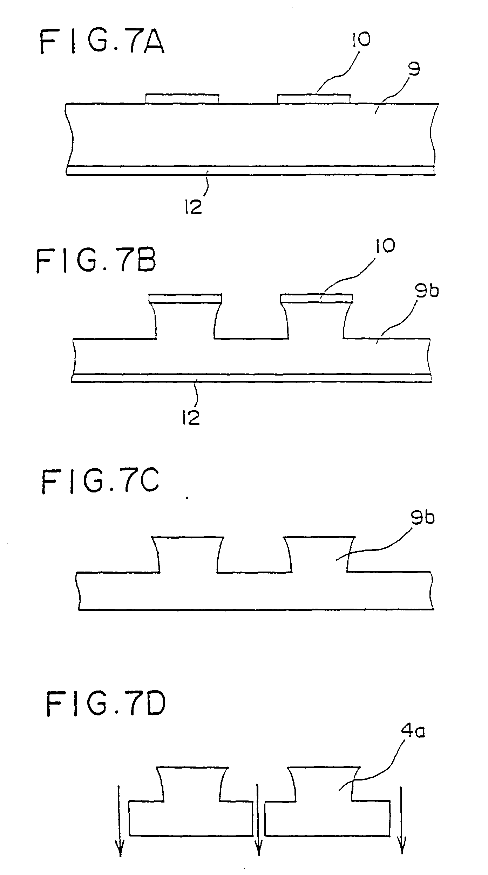

FIG. 7A, 7B, 7C and 7D are views including step explanatory diagrams FIG. 7A to FIG. 7D showing another embodiment of the method of producing heat sinks according to the present invention. The procedure of the production will be described along the step sectional views FIG. 7A - 7D.

First, as shown in FIG. 7A, on one surface of a plate 9 such as an oxygen-free copper plate having a thickness identical with the plate thickness of each of heat sinks to be formed, small resist films 10 are provided with predetermined intervals in order to form the projecting portions of the heat sinks. Then, a resist film 12 is formed over the whole surface of the other surface of the plate 9.

Next, as shown in FIG. 7B, wet-type etching is performed in the same manner as mentioned above on the one surface of the plate 9 by use of the small resist films 10 as masks. The etching is continued, for example, up to half the thickness of the plate 9 so as to form convex portions 9b with the resist films, the convex portions 9b being connected to each other while having individual projecting portions respectively.

Further, as shown in FIG. 7C, the small resist films 10 and the resist film 12 are removed from the convex bodies 9b. Then, as shown in FIG.7D, the continuous body of the convex portions 9b is divided uniformly at the etched portions by pressing or machining such as cutting or the like so that individual convex heat sinks 4a are obtained. At this time, the pressing may be performed from either the one surface where the projecting portions are formed or the other surface of the body.

As described above, in the heat sink producing method in this embodiment, both the wet-type etching and machining are used in combination. In this case, however, etching is performed from only one surface side, so that there is a feature that it is possible to desirably establish the depth of etching, that is, the height of the projecting portions.

This point can be regarded as a contrastive advantage in comparison with the case of Embodiment 3 where, since etching is performed from the opposite surfaces, checking before the step of etching is required so as to adjust the respective intervals of upper and lower masks in order to establish the height of each projecting portion to be a predetermined value.

The other features and effects with respect to the shape, accuracy, and so on, of the heat sinks to be formed are the same as those which were described in Embodiment 3.

### Embodiment 5

As modifications of the method of producing heat sinks which were described in the above Embodiments 3 and 4, further embodiments of a heat sink have a silver (Ag) plated surface in the position to which a semiconductor chip is to be attached. The embodiment and the structure and effects thereof will be described below.

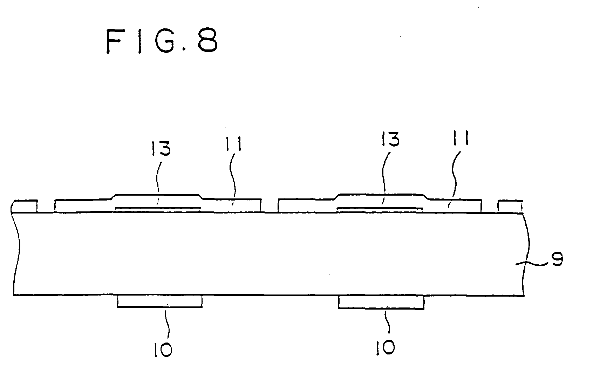

FIG. 8 is a sectional view illustrating the state of a first stage (stage corresponding to the step of the drawing FIG. 6A) in producing heat sinks having silver-plated surfaces respectively. As shown in the drawing, before large resist films 11 are formed on a plate 9 in predetermined positions thereof, first, silver-plated surfaces 13 each having a predetermined area are formed on the plate 9 at positions where semiconductor chips 3 are to be attached on the respective heat sinks which will be formed later. Preferably, it is general to set this predetermined area to be larger than, for example, to be 4 to 9 times as large as, the area occupied by each semiconductor chip 3.

After the silver-plated surfaces 13 are formed, the large resist films 11 are formed on one surface, that is, on this silver-plated surface side, of the plate 9, and, on the other hand, small resist films 10 are formed on the other surface opposite to the silver-plated surface side. Then, after wet-type etching is performed in the same manner as in the formation method of Embodiment 3, the resist films are removed so that heat sinks 4a having the silver-plated surfaces 13 respectively, according to the present invention are obtained. Then, the heat sinks 4a having the silver-plated surfaces 13 respectively are subjected to dark color treatment by application of the method described in the embodiment of FIG. 2 so as to obtain heat sinks 4b each having a dark color treatment layer 7 on the surface other than the silver-plated surface 13. Since the silver-plated surface cannot be subjected to dark color treatment, it is easy to form such a heat sink 4b having a silver-plated surface 13.

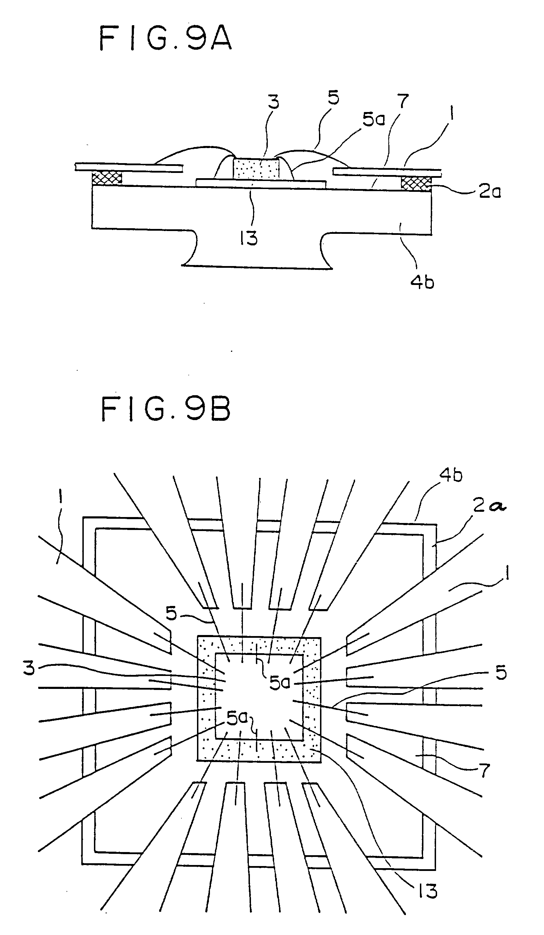

FIG. 9A is a sectional view illustrating the state, before packaging, of an embodiment of a device formed by using such a heat sink having a silver-plated surface, and FIG. 9B is a plan view of the same. In the diagrams of FIG.9A and 9B, the reference numeral 13 represents a silver-plated surface formed at and around the position of a heat sink 4b to which a semiconductor chip 3 is to be attached. The other configuration except wires 5a is the same as that of the semiconductor device shown in FIG. 1A or the like.

The device of this embodiment has a feature in that wires 5a led out from some bonding pads provided for grounding in the semiconductor chip 3 are connected to the silver-plated surface 13 directly so that the silver-plated surface 13 can be commonly used for grounding and the leads can be used for other purposes correspondingly.

In this embodiment, description was made as to an example of wire connection in the case of a heat sink 4b having a silver-plated surface 13 and being subjected to formation of a dark color treatment layer 7. It is a matter of course that the same effects of the silver-plated surface can be obtained, for example, even in the case of use of a heat sink 4a provided with a silver-plated surface 13 while provided with no dark color treatment layer 7.

### Embodiment 6

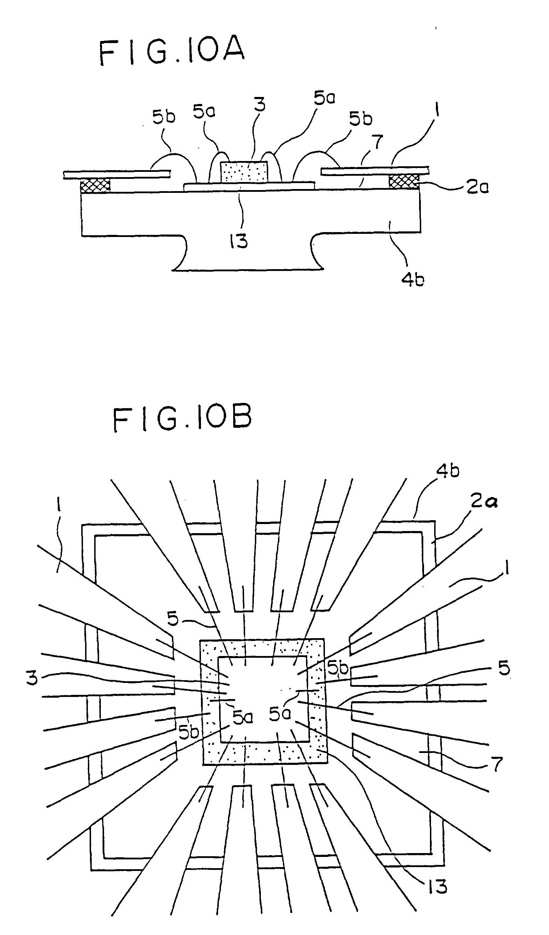

FIG.10A is a sectional view illustrating the state, before packaging, of another embodiment of a semiconductor device formed by using such a heat sink having a silver-plated surface, and FIG. 10B is a plan view of the same. In FIGs. 10A and 10B, the reference numeral 13 represents a silver-plated surface formed on the surface of a heat sink 4b at and around a position on which a semiconductor chip 3 is to be attached. Except wires 5b, the configuration is the same as the device of the embodiment of FIG. 9 and so on.

In this embodiment, wires 5b are for direct connection from the silver-plated surface 13 (heat sink 4b) to a small number of leads 1, while wires 5a are for direct connection from a plurality of grounding pads of the semiconductor chip 3 to the silver-plated surface 13 in the same manner as in the case of FIG. 9.

Owing to this wire connection configuration using such a silver-plated surface 13, not only the wires 5a led out from some bonding pads provided for grounding on the semiconductor chip 3 can be connected directly to the silver-plated surface 13 so that the leads 1 may be used for other purposes correspondingly, but also for example bonding is made from a plurality of grounding pads on the semiconductor chip 3 to the surface of the heat sink 4b and from the heat sink to a small number of leads 1 so that it is possible to obtain advantages in that the grounding potential is stable and numbers of grounding points are obtained by means of a small number of leads. In FIG. 10A, the illustration of ordinary bonding wires 5 is omitted.

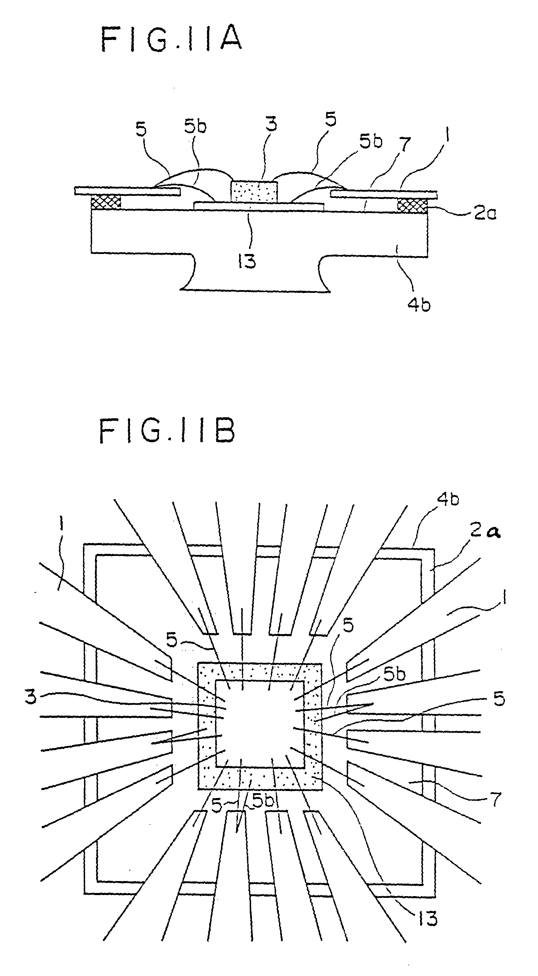

FIG. 11A is a sectional view showing the state, before packaging, of another embodiment of the device formed by using a heat sink having a silver-plated surface, and FIG. 11B is a plan view of the same. In FIGs. 11A and 11B, the reference numeral 13 represents a silver-plated surface formed on the surface of a heat sink 4b at and around a position on which a semiconductor chip 3 is to be attached. Except the state of wire bonding, the configuration is the same as the device of the embodiment of FIG. 10, and so on.

In the configuration of FIGs. 11A and 11B, bonding is made from the grounding leads 1 to the silver-plated surface 13 of the heat sink 4b through wires 5b and to a plurality of grounding pads of the semiconductor chip 3 through wires 5. The sequence of the connection is such that, in comparison between the grounding pads and the silver-plated surface, connection is made first from the leads to the silver-plated surface 13 which is near the leads, and connection is then made from the leads to the grounding pads which are far from the leads.

In this configuration, there is an advantage that the potential of the rear surface of the semiconductor chip 3 can be agreed with the potential of the ground, and the quality of bonding is superior in comparison with the device of the embodiment of FIG. 10 because, for example, the bending deformation of the wires 5 at their upper portions is gentle.

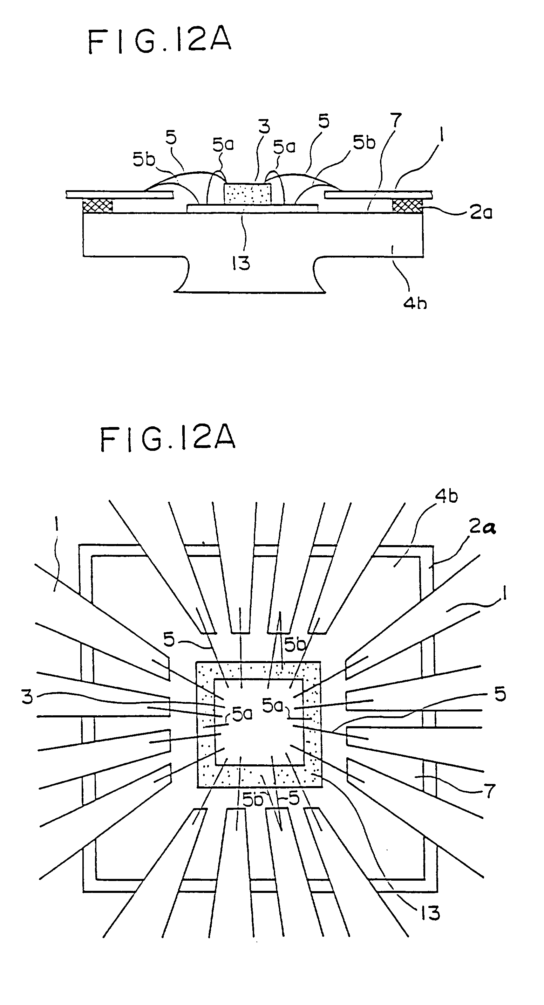

Further, FIG.12A is a sectional view showing the state, before packaging, of a further embodiment of the device formed by using a heat sink having a silver-plated surface, and FIG. 12B is a plan view of the same. In FIGs.12A and 12B, the reference numeral 13 represents a silver-plated surface formed on the surface of a heat sink 4b at and around a position on which a semiconductor chip 3 is to be attached. Except the state of wire bonding, the configuration is the same as the device of the embodiments of Figs. 10 and 11, and so on.

In this configuration, the methods of connection of the wires 5a and 5b through the silver-plated surface 13 shown in FIGs. 11 and 12 are used in combination. That is, wires 5a for connection between the grounding pads of the semiconductor chip 3 and the heat sink and wires 5b for connection between a small number of leads and the heat sink are combined suitably so as to generate an advantage that a preferable embodiment of grounding connection can be obtained.

### Embodiment 7

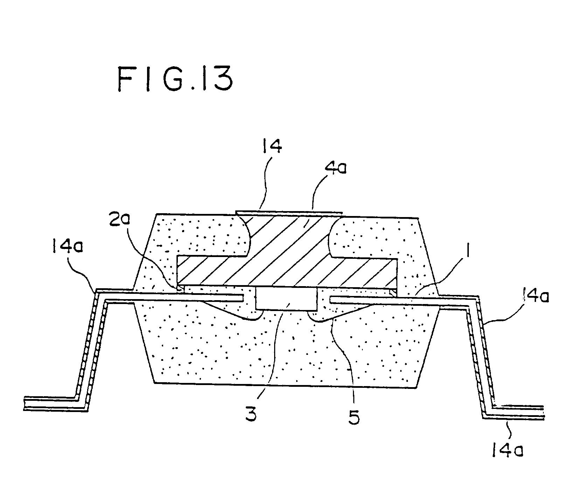

FIG. 13 is a sectional view illustrating another embodiment of a semiconductor device with a heat sink according to the present invention. Main configuration of the device of this embodiment is almost the same as that of the device of FIG. 1A. The device of FIG. 13 has a feature in that a solder-plated layer 14 is provided on the top surface of a projecting portion which constitutes an exposed portion of a heat sink 4a.

That is, omitted in the above description, such solder plating 14a as illustrated is conventionally given to leads 1 at portions which are made external terminals in this kind of semiconductor device, for the sake of convenience in practical mounting. The above-mentioned solder-plated layer 14 is formed simultaneously with formation of the solder plating 14a in the same step.

By adding this solder-plated layer 14, it is possible to obtain an effect to improve the prevention of a heat sink from being eroded, for example, in comparison with the case where this surface is coated with such a dark color treatment layer 7 as described in the embodiment of FIG. 2. Further, it is also possible to obtain such an effect in practical use that it is convenient on working such as soldering or the like in the case of applying potential (including a grounding potential) to a heat sink which is insulated electrically.

As has been described above, according to the present invention, in a semiconductor device with a heat sink in which one end surface of a heat sink made from such as metal having a high heat-conductivity is exposed, the heat sink is shaped into a convex or reversed T shape in cross-section having a projecting portion which is scraped out so that the condition X>Y is established between the top surface width X of the projecting portion and the minimum width Y at the side surface portion of the projecting portion. Accordingly, the adhesive property of sealing resin to the heat sink is improved, so that the reliability of this kind of semiconductor device is improved.

Among the respective surfaces of the convex heat sink, that is, among the top surface (surface A) of the projecting portion, the side surface (surface B) of the projecting portion, and the bottom surface (surface C), the surface roughness of the surfaces A and C is made to be no more than 30 *µ*m. Further, the deviation from the parallelism between the surfaces A and C is made to be no more than 30 *µ*m. Although it is not always necessary to make the surface B be a mirror surface, if the surface B is made to have a surface roughness of about 50 *µ*m, the surface of the projecting portion is prevented from being involved in sealing resin and coated therewith. Accordingly, it is possible to ensure an exposed surface of a heat sink which is stable and beautiful with no resin separated therefrom. It is also possible to keep stable quality of wire bonding and to ensure the adhesive property of sealing resin.

Further, since a narrow insulating tape is used for bonding a heat sink to leads of a lead frame, the forward end portions of the respective leads abut against the heat sink with the insulating tape as a fulcrum so that the leads are fixed stiffly. Accordingly, it is possible to perform stable bonding of wires in this state.

Further, in accordance with the state of provision of the insulator, not only the length of the leads can be increased but also the quantity of the insulator can be reduced, for example, by providing the insulator along not all the sides of the bottom of the heat sink but along only a pair of opposite sides of the bottom, so that there arises an effect that the semiconductor device can be improved in its reliability and moisture resistant property.

Since the surface of a heat sink is subjected to dark color treatment such as blackening treatment, the recognition of leads in wire bonding is made stable, so that not only the quality of the bonding is improved, but also the adhesive property of sealing resin to the heat sink is improved.

With a heat sink having through holes, sealing resin is injected into the through holes so that upper and lower resins which constitute a package and which sandwich a lead frame therebetween communicate with each other tightly through the through holes and molded stiffly. Accordingly, there is an effect in formation of a stiff package. It is also possible to improve the adhesive property of the sealing resin to the heat sink.

According to the method of producing heat sinks according to the present invention, projecting portions of the heat sinks are formed by etching, so that no mechanical stress is given to the heat sinks and it is therefore possible to produce heat sinks which are stable in flatness and parallelism. Heat sinks are generally stable in quality when they are produced by only etching. In the case of using both etching and pressing, however, etching may be performed from only one surface of a raw body, so that the depth of etching can be easily controlled and the cost can be therefore reduced.

Further, with this method, it is easy to form a silver-plated surface of a predetermined area in the position of a heat sink to which a semiconductor device is to be attached. This silver-plated surface gives a conspicuous effect to a wide variety of wire bonding systems in the vicinity of the chip to contribute to an improvement in performance of the device.

## Claims

1. A semiconductor device comprising:
(a) a convex heat sink (4b) made from a high heat-conductive material and comprising a base defining a bottom surface, and a projecting portion projecting from said base in a direction opposite to said bottom surface, said projecting portion having a top surface whose width is larger than the width of said projecting portion at a predetermined position between said top surface and said base;
(b) a lead frame arranged on the bottom surface side of said base and comprising a plurality of leads (1) each having one end portion overlapping said bottom surface, the end faces of the end portions defining a space of said lead frame;
(c) a semiconductor element (3) mounted on said bottom surface within said space of the lead frame;
(d) a plurality of wires (5) for electrically connecting said plurality of leads to a plurality of pads provided on said semiconductor element, respectively;
(e) an insulator (2a) disposed between said bottom surface and the end portions of at least some of said leads so as to separate the leads from said heat sink by a predetermined distance and so as to join the leads with said bottom surface; and
(f) resin for sealing said leads, said semiconductor element, said wires, said insulator and said heat sink except said top surface,
**characterized in** that said heat sink has a dark color surface treatment layer (7) formed on its surface.

2. A semiconductor device according to Claim 1, in which said insulator (2a) is provided along all sides of said bottom surface.

3. A semiconductor device according to Claim 1, in which said insulator (2a) is provided along a pair of opposite sides of said bottom surface.

4. A semiconductor device according to any one of the preceding claims, in which, in said heat sink (4a), the area of said top surface of said projecting portion is larger than the minimum cross-sectional area of said projecting portion.

5. A semiconductor device according to any one of the preceding claims, in which said high heat-conductive material consists of copper, aluminum, silver or gold, or an alloy of any two or more of these metal elements.

6. A semiconductor device according to any one of the preceding claims, in which the base of said heat sink (4c) has a quadrangular shape in cross-section, and has a plurality of symmetrically arranged through holes (8) extending perpendicularly to the bottom surface.

7. A semiconductor device according to any one of the preceding claims, in which the top surface of said projecting portion of said heat sink has surface roughness no more than 30 *µ*m.

8. A semiconductor device according to any one of the preceding claims, in which in said heat sink, deviation from parallelism between the top surface of said projecting portion and said bottom surface is no more than 30 *µ*m, the deviation being defined as a value obtained by substracting the minimum value of the distance between said two surfaces from the maximum value thereof.

9. A semiconductor device according to any one of the preceding claims, in which, in said heat sink, the top surface of said projecting portion is different in surface shape from said bottom surface.

10. A semiconductor device according to any one of the preceding claims, in which a silver-plated surface (13) larger than a chip area of said semiconductor element (3) is provided in a position of said bottom surface where said semiconductor element is mounted.

11. A semiconductor device according to Claim 10, in which said device comprises wires (5a) for making connection from grounding potential pads of said semiconductor element (3) to said silver-plated surface and for making connection from said silver-plated surface to corresponding ones of said leads (1).

12. A semiconductor device according to Claim 10, in which said device comprises wires (5) for making connection from grounding potential pads of said semiconductor element (3) to corresponding ones of said leads (1) and for making connection from said silver-plated surface to said corresponding leads.

13. A semiconductor device according to claim 10 comprising wires for making connection from grounding potential pads to said silver-plated surface and for making connection from said grounding potential pads to said corresponding leads.

14. A method of producing at least one convex heat sink for at least one semiconductor device, comprising the steps of:
(a) forming first resist films (10) selectively on one surface of a plate (9) of high heat-conductive material in order to form at least one projecting portion of said at least one heat sink;
(b) forming second resist films (11) selectively on the other surface of said plate opposite to said one surface in order to form at least one bottom surface of said at least one convex heat sink;
(c) conducting etching on said plate from said one and the other surfaces thereof by using said first and second resist films as masks until said plate is separated into portions divided at positions of gaps provided between adjacent resist films in steps (a) and (b) to obtain said at least one heat sink; and
(d) forming a dark color surface treatment layer (7) on the surface of said projecting portion by an oxidation treatment.

15. A method of producing at least one convex heat sink for at least one semiconductor device, comprising the steps of:
(a) forming first resist films (10) selectively on one surface of a plate (9) of a high heat-conductive material in order to form at least one projecting portion of said at least one heat sink;
(b) forming a second resist film (12) over the whole of the other surface of said plate opposite said one surface;
(c) conducting etching on said material from said one surface by using said first resist films as masks until said at least one projecting portion is formed in a desired shape;
(d) dividing said plate, by machining, at regions subjected to the etching to thereby obtain said at least one heat sink; and
(e) forming a dark color surface treatment layer (7) on the surface of said projecting portion by an oxidation treatment.

16. The method according to claim 14 or 15, further comprising the step of forming the shape and structure of a side surface portion of said projecting portion of said heat sink by wet-type etching.

17. The method according to Claim 14 or 15, in which oxygen free copper is used as the material of said plate (9), and an etching liquid of iron (II) chloride is used in said etching.

18. The method according to Claim 14 or 15, in which before formation of said second resist film(s), at least one silver-plated surface (13) is formed in the position on said other surface of said plate on which said at least one semiconductor element will be bonded and fixed later.

## Patentansprüche

1. Halbleiterbaustein mit
(a) einem konvexen Wärmeableiter (4b) aus einem hochwärmeleitfähigen Material mit einer einen Boden bestimmenden Basis und einem von der Basis in Richtung entgegengesetzt zum Boden vorstehenden Vorsprung, der eine Oberseite hat, deren Breite größer ist als die Breite des Vorsprungs an einer vorherbestimmten Stelle zwischen der Oberseite und der Basis;
(b) einem an dem Boden der Basis angeordneten Anschlußleiterrahmen, der eine Vielzahl von Anschlußleitungen (1) aufweist, die jeweils einen den Boden überlappenden Endabschnitt haben, wobei die Stirnflächen der Endabschnitte einen Raum des Anschlußleitungsrahmens bestimmen;
(c) einem an dem Boden innerhalb des Raums des Anschlußleitungsrahmens angebrachten Halbleiterbauelement (3);
(d) einer Vielzahl von Drähten (5) zum elektrischen Verbinden der Vielzahl von Anschlußleitungen mit einem entsprechenden einer Vielzahl von am Halbleiterbauelement vorgesehenen Anschlußflächen;
(e) einem zwischen dem Boden und den Endabschnitten mindestens einiger der Anschlußleitungen vorgesehenen Isolator (2a), der die Anschlußleitungen vom Wärmeableiter um eine vorherbestimmte Entfernung trennt und die Anschlußleitungen mit dem Boden verbindet; und
(f) einem Harz zum dichten Einschluß der Anschlußleitungen, des Halbleiterbauelements, der Drähte, des Isolators und des Wärmeableiters mit Ausnahme der Oberseite,
**dadurch gekennzeichnet,** daß auf der Oberfläche des Wärmeableiters eine Oberflächenbehandlungsschicht (7) in dunkler Farbe gebildet ist.

2. Halbleiterbaustein nach Anspruch 1, bei dem der Isolator (2a) längs aller Seiten des Bodens vorgesehen ist.

3. Halbleiterbaustein nach Anspruch 1, bei dem der Isolator (2a) längs eines Paares einander gegenüberliegender Seiten des Bodens vorgesehen ist.

4. Halbleiterbaustein nach einem der vorhergehenden Ansprüche, bei dem in dem Wärmeableiter (4) die Fläche der Oberseite des Vorsprungs größer ist als die Mindestquerschnittsfläche des Vorsprungs.

5. Halbleiterbaustein nach einem der vorhergehenden Ansprüche, bei dem das hochwärmeleitfähige Material aus Kupfer, Aluminium, Silber oder Gold oder einer Legierung aus zwei oder mehreren dieser Metallelemente besteht.

6. Halbleiterbaustein nach einem der vorhergehenden Ansprüche, bei dem die Basis des Wärmeableiters (4c) im Querschnitt viereckige Gestalt hat und eine Vielzahl symmetrisch angeordneter Durchgangslöcher (8) besitzt, die sich rechtwinklig zum Boden erstrecken.

7. Halbleiterbaustein nach einem der vorhergehenden Ansprüche, bei dem die Oberseite des Vorsprungs des Wärmeableiters eine Oberflächenrauhheit von nicht mehr als 30 *µ*m besitzt.

8. Halbleiterbaustein nach einem der vorhergehenden Ansprüche, bei dem in dem Wärmeableiter die Abweichung von der Parallelität zwischen der Oberseite des Vorsprungs und dem Boden nicht mehr als 30 *µ*m beträgt, wobei die Abweichung als ein Wert definiert ist, der durch Subtraktion des Kleinstwertes der Entfernung zwischen den beiden Oberflächen vom Höchstwert derselben erhalten wird.

9. Halbleiterbaustein nach einem der vorhergehenden Ansprüche, bei dem in dem Wärmeableiter sich die Form der Oberseite des Vorsprungs von der des Bodens unterscheidet.

10. Halbleiterbaustein nach einem der vorhergehenden Ansprüche, bei dem eine silberplattierte Oberfläche (13), die größer ist als die Chipfläche des Halbleiterbauelements (3), an einer Stelle am Boden vorgesehen ist, wo das Halbleiterbauelement angebracht ist.

11. Halbleiterbaustein nach Anspruch 10, bei dem der Baustein Drähte (5a) für die Herstellung einer Verbindung von Erdungspotential-Anschlußflächen des Halbleiterbauelements (3) zu der silberplattierten Oberfläche und zur Herstellung einer Verbindung von der silberplattierten Oberfläche zu entsprechenden der Anschlußleitungen (1) aufweist.

12. Halbleiterbaustein nach Anspruch 10, bei dem der Baustein Drähte (5) zum Herstellen einer Verbindung von Erdungspotential-Anschlußflächen des Halbleiterbauelements (3) zu entsprechenden der Anschlußleitungen (1) und zum Herstellen einer Verbindung von der silberplattierten Oberfläche zu den entsprechenden Anschlußleitungen aufweist.

13. Halbleiterbaustein nach Anspruch 10 mit Drähten zum Herstellen einer Verbindung von Erdungspotential-Anschlußflächen zu der silberplattierten Oberfläche und zum Herstellen einer Verbindung von den Erdungspotential-Anschlußflächen zu den entsprechenden Anschlußleitungen.

14. Verfahren zum Herstellen mindestens eines konvexen Wärmeableiters für mindestens einen Halbleiterbaustein, welches folgende Schritte aufweist:
(a) selektives Ausbilden erster Resistfilme (10) auf einer Oberfläche einer Platte (9) aus hochwärmeleitfähigem Material zur Schaffung mindestens eines Vorsprungs des wenigstens einen Wärmeableiters;
(b) selektives Ausbilden zweiter Resistfilme (11) auf der anderen Oberfläche der Platte gegenüber der einen Oberfläche zur Schaffung mindestens eines Bodens des mindestens einen konvexen Wärmeableiters;
(c) Ätzen der Platte von der einen und der anderen Oberfläche derselben aus unter Verwendung der ersten und zweiten Resistfilme als Masken, bis die Platte an Positionen von in den Schritten (a) und (b) zwischen benachbarten Resistfilmen vorgesehenen Lücken in Abschnitte unterteilt ist, um den mindestens einen Wärmeableiter zu erhalten; und
(d) Ausbilden einer Oberflächenbehandlungsschicht (7) in dunkler Farbe auf der Oberfläche des Vorsprungs durch Oxidationsbehandlung.

15. Verfahren zum Herstellen mindestens eines konvexen Wärmeableiters für mindestens einen Halbleiterbaustein, welches folgende Schritte aufweist:
(a) selektives Ausbilden erster Resistfilme (10) auf einer Oberfläche einer Platte (9) aus einem hochwärmeleitfähigen Material zur Schaffung mindestens eines Vorsprungs des mindestens einen Wärmeableiters;
(b) Ausbilden eines zweiten Resistfilms (12) über die gesamte andere Oberfläche der Platte gegenüber der einen Oberfläche;
(c) Ätzen des Materials von der einen Oberfläche unter Verwendung der ersten Resistfilme als Masken, bis der mindestens eine Vorsprung in einer gewünschten Gestalt gebildet ist;
(d) Unterteilen der Platte durch Oberflächenbearbeitung in dem Ätzen unterworfenen Regionen, um auf diese Weise den mindestens einen Wärmeableiter zu erhalten; und
(e) Ausbilden einer Oberflächenbehandlungsschicht (7) in dunkler Farbe auf der Oberfläche des Vorsprungs durch eine Oxidationsbehandlung.

16. Verfahren nach Anspruch 14 oder 15, ferner mit dem Schritt des Ausbildens der Form und Struktur einer Seitenfläche des Vorsprungs des Wärmeableiters durch naßchemisches Ätzen.

17. Verfahren nach Anspruch 14 oder 15, bei dem sauerstofffreies Kupfer als Material der Platte (9) verwendet wird und beim Ätzen eine Ätzflüssigkeit aus Eisen(II)chlorid verwendet wird.

18. Verfahren nach Anspruch 14 oder 15, bei dem vor dem Ausbilden des/der zweiten Resistfilm(e) mindestens eine silberplattierte Oberfläche (13) an der Stelle der anderen Oberfläche der Platte gebildet wird, an der das mindestens eine Halbleiterbauelement später kontaktiert und fixiert wird.

## Revendications

1. Dispositif à semi-conducteur comportant :
(a) un puits (4b) de chaleur convexe réalisé à partir d'un matériau à forte conductivité thermique et comportant une base définissant une surface de fond et une partie faisant saillie faisant saillie de la base suivant une direction opposée à la surface de fond, la partie faisant saillie ayant une surface supérieure dont la largeur est supérieure à la largeur de la partie faisant saillie en une position déterminée à l'avance entre la surface supérieure et la base ;
(b) un bâti de conducteurs disposé sur le côté de surface de fond de la base et comportant une pluralité de conducteurs (1) ayant chacun une partie d'extrémité chevauchant la surface de fond, les faces d'extrémités des parties d'extrémités définissant un espace du bâti de conducteurs ;
(c) un élément (3) à semi-conducteur monté sur la surface de fond à l'intérieur de l'espace du bâti de conducteurs ;
(d) une pluralité de fils (5) pour une connexion électrique de la pluralité de conducteurs à une pluralité de tampons disposés sur l'élément à semi-conducteur, respectivement ;
(e) un isolant (2a) disposé entre la surface de fond et les parties d'extrémités de au moins certains des conducteurs de manière à séparer les conducteurs du puits de chaleur d'une distance déterminée à l'avance et de manière à réunir les conducteurs à la surface de fond ; et
(f) de la résine pour sceller les conducteurs, l'élément à semi-conducteur, les fils, l'isolant et le puits de chaleur à l'exception de la surface supérieure,
caractérisé en ce que le puits de chaleur a une couche (7) de traitement de surface de couleur sombre formée à sa surface.

2. Dispositif à semi-conducteur suivant la revendication 1, dans lequel l'isolant (2a) est disposé le long de tous les côtés de la surface de fond.

3. Dispositif à semi-conducteur suivant la revendication 1, dans lequel l'isolant (2a) est disposé le long d'une paire de côtés opposés de la surface de fond.

4. Dispositif à semi-conducteur suivant l'une quelconque des revendications précédentes, dans lequel, dans le puits (4a) de chaleur, l'aire de la surface supérieure de la partie faisant saillie est plus grande que l'aire de section transversale minimale de la partie faisant saillie.

5. Dispositif à semi-conducteur suivant l'une quelconque des revendications précédentes, dans lequel le matériau à conductivité thermique élevée est constituée de cuivre, d'aluminium, d'argent ou d'or, ou d'un alliage de n'importe lequel de deux ou plusieurs de ces éléments métalliques.

6. Dispositif à semi-conducteur suivant l'une quelconque des revendications précédentes, dans lequel la base du puits (4c) de chaleur a une forme quadrangulaire en section transversale, et comporte une pluralité de trous (8) de traversée agencés symétriquement s'étendant perpendiculairement à la surface de fond.

7. Dispositif à semi-conducteur suivant l'une quelconque des revendications précédentes, dans lequel la surface supérieure de la partie faisant saillie du puits de chaleur a une rugosité de surface qui n'est pas supérieure à 30 µm.

8. Dispositif à semi-conducteur suivant l'une quelconque des revendications précédentes, dans lequel, dans le puits de chaleur, l'écart par rapport au parallélisme entre la surface supérieure de la partie faisant saillie et la surface de fond n'est pas supérieur à 30 µm, l'écart étant défini en tant qu'une valeur obtenue en soustrayant la valeur minimale de la distance entre les deux surfaces de sa valeur maximale.

9. Dispositif à semi-conducteur suivant l'une quelconque des revendications précédentes, dans lequel, dans le puits de chaleur, la surface supérieure de la partie faisant saillie est différente en forme de surface de la surface de fond.

10. Dispositif à semi-conducteur suivant l'une quelconque des revendications précédentes, dans lequel une surface (13) plaquée à l'argent supérieure à une aire de puce de l'élément (3) à semi-conducteur est disposée dans une position de la surface de fond où l'élément à semi-conducteur est monté.

11. Dispositif à semi-conducteur suivant la revendication 10, dans lequel le dispositif comporte des fils (5a) pour réaliser une connexion à partir des patins de potentiel de mise à la terre de l'élément (3) à semi-conducteur vers la surface plaquée à l'argent et pour réaliser une connexion à partir de la surface plaquée à l'argent vers des conducteurs correspondants des conducteurs (1).

12. Dispositif à semi-conducteur suivant la revendication 10, dans lequel le dispositif comporte des fils (5) pour réaliser une connexion à partir des patins de potentiel de mise à la terre de l'élément (3) à semi-conducteur vers des conducteurs correspondants des conducteurs (1) et pour réaliser une connexion à partir de la surface plaquée à l'argent vers les conducteurs correspondants.

13. Dispositif à semi-conducteur suivant la revendication 10, comportant des fils pour réaliser une connexion à partir des patins de potentiel de mise à la terre vers la surface plaquée à l'argent et pour réaliser une connexion à partir des patins de potentiel de mise à la terre vers les conducteurs correspondants.

14. Procédé de production d'au moins un puits thermique ou de chaleur convexe pour au moins un dispositif à semi-conducteur comportant les étapes qui consistent à :
(a) former de premières pellicules (10) de resist sélectivement sur une surface d'une plaque (9) de matériau de haute conductivité thermique afin de former au moins une partie faisant saillie dudit au moins un puits thermique ;
(b) former de secondes pellicules (11) de resist sélectivement sur l'autre surface de la plaque opposée à ladite une surface afin de former au moins une surface de fond dudit au moins un puits thermique convexe;
(c) effectuer une gravure sur la plaque à partir desdites une et autre surfaces en utilisant les premières et secondes pellicules de resist en tant que masques jusqu'à ce que la plaque soit séparée en des parties divisées en des positions d'interstices formées entre des pellicules de resist adjacentes dans les étapes (a) et (b) pour obtenir ledit au moins un puits de chaleur ; et
(d) former une couche (7) de traitement de surface de couleur sombre sur la surface de la partie faisant saillie par un traitement d'oxydation.

15. Procédé de production d'au moins un puits thermique convexe pour au moins un dispositif à semi-conducteur, comportant les étapes qui consistent à :
(a) former de premières pellicules (10) de resist sélectivement sur une surface d'une plaque (9) d'un matériau à conductivité thermique élevée afin de former au moins une partie faisant saillie dudit au moins un puits thermique ;
(b) former une seconde pellicule (12) de resist sur tout l'ensemble de l'autre surface de la plaque opposée à ladite une surface ;
(c) effectuer une gravure sur le matériau à partir de ladite une surface en utilisant les premières pellicules de resist en tant que masques jusqu'à ce que ladite au moins une partie faisant saillie soit formée suivant une forme souhaitée ;
(d) diviser la plaque, par usinage, en des régions soumises à la gravure pour ainsi obtenir ledit au moins un puits thermique ; et
(e) former une couche (7) de traitement de surface de couleur sombre sur la surface de la partie faisant saillie par un traitement d'oxydation.

16. Dispositif à semi-conducteur suivant la revendication 14 ou 15, comportant en outre l'étape qui consiste à former la forme et la structure d'une partie de surface latérale de la partie faisant saillie du puits thermique par gravure de type par voie humide.

17. Procédé suivant la revendication 14 ou 15, dans lequel du cuivre sans oxygène est utilisé en tant que matériau de la plaque (9), et un liquide de gravure en chlorure de fer (II) est utilisé dans la gravure.

18. Procédé suivant la revendication 14 ou 15, dans lequel avant la formation de la seconde ou des secondes pellicules de resist, au moins une surface (13) plaquée à l'argent est formée dans la position sur l'autre surface de la plaque sur laquelle ledit au moins un élément à semi-conducteur sera lié et fixé ultérieurement.
